# EUROPÄISCHE PATENTSCHRIFT

(11) **EP 0 544 148 B1**
(45) Veröffentlichungstag und Bekanntmachung des Hinweises auf die Patenterteilung: **08.07.1998**
(21) Anmeldenummer: 92119301.7
(22) Anmeldetag: 11.11.1992
(51) Int. Cl.: G11C 16/06

(54) **Verfahren zum Programmieren von programmierbaren integrierten Schaltkreisen**
Method for programming programmable integrated circuits
Méthode de programmation pour circuits intégrés

(30) Priorität: 28.11.1991 DE 4139153
(43) Veröffentlichungstag der Anmeldung: 02.06.1993
(73) Patentinhaber: SIEMENS AKTIENGESELLSCHAFT, 80333 München (DE)
(72) Erfinder: Lesch, Hilmar, Dipl.-Ing., 82515 Wolfratshausen (DE)

(56) Entgegenhaltungen:
- WO-A-91/07753
- US-A- 4 481 627
- PATENT ABSTRACTS OF JAPAN vol. 5, no. 175 (P-88)(847) 11. November 1981 & JP-A-56 105 400 ( HITACHI SEISAKUSHO KK ) 21. August 1981
- EDN ELECTRICAL DESIGN NEWS. Bd. 33, Nr. 15, 21. Juli 1988, NEWTON, MASSACHUSETTS US Seiten 182 - 190 DAN STRASSBERG 'Feature-packed universal programmers deliver good value'

## Beschreibung

Auf Schaltungsplatinen, z.B. Baugruppen für elektrotechnische Einrichtungen, sind in zunehmendem Maße programmierbare integrierte Schaltkreise angeordnet. Programmierbare integrierte Schaltkreise stellen bekannterweise PLA-Schaltkreise (Programmable Logic Array), EPROM-Speicher (Programmable Read-Only Memory), FLASH-EPROM's, usw. dar. Die programmierbaren integrierten Schaltkreise werden in hierfür vorgesehene Öffnungen der Schaltungsplatine eingelötet oder in einen auf der Schaltungsplatine angeordneten Stecksockel eingesteckt.

Im Rahmen der Herstellung von Schaltungsplatinen bzw. Baugruppen mit programmierbaren integrierten Schaltkreisen werden die hierfür vorgesehenen Schaltkreise zunächst gelagert. Anschließend findet eine Programmierung der noch unprogrammierten, integrierten Schaltkreise mit unterschiedlichsten Programmen an einem Spezialprogrammierplatz statt. Die nun programmierten integrierten Schaltkreise werden erneut gelagert, wobei eine programmindividuelle und damit weiträumigere Lagerung erforderlich ist. Anschließend werden die programmierten integrierten Schaltkreise entweder automatisch - überwiegend bei Lötung der integrierten Schaltkreise - oder manuell - überwiegend bei Stecksockeln - auf die jeweilige Schaltungsplatine aufgebracht. Bei diesem Bestücken ist darauf zu achten, daß auf die jeweilige Schaltungsplatine der programmierte integrierte Schaltkreis mit dem hierfür vorgesehenen Programm aufgebracht wird. Bei größeren elektrotechnischen Systemen, wie z.B. bei einem Kommunikationssystem, sind Bestückungsverwechslungen aufgrund der Vielfalt der eingesetzten Programme nur mit erheblichem Aufwand zu vermeiden. Desweiteren ist aus der WO-A-9 107 753 ein Verfahren zum Programmieren von programmierbaren integrierten Schaltkreisen bekannt, die bereits auf einer Schaltungsplatine angeordnet sind. Hierzu werden die Kontakte eines Kontaktkopfes direkt auf die Anschlußelemente des integrierten Schaltkreises aufgesetzt. Der integrierte Schaltkreis wird anschließend mit schaltkreisspezifischen Programmierroutinen und mit Mitteln zur Erzeugung der entsprechenden Programmiersignale programmiert (siehe Präambel des Anspruchs 1).

Aus der US-A-4 481 627 ist eine funktionale Prüfung der bestückten Schaltungsplatinen bzw. Baugruppen mit Hilfe einer automatischen Prüfeinrichtung bekannt. Für die Verbindung der Prüfeinrichtung mit den Anschlußelementen der Schaltungskkomponenten und insbesondere der programmierten integrierten Schaltkreise der Schaltungsplatinen bzw. der Baugrupppen werden als Meßfühler Nadeladapter eingesetzt. Diese Nadeladapter werden mit Hilfe von Federkräften oder pneumatischen Kräften an die verlöteten Anschlußelemente der integrierten Schaltkreise bzw. der Stecksockel gedrückt und somit die erforderliche elektrische Verbindung hergestellt.

Die der Erfindung zugrundeliegende Aufgabe besteht darin, den Aufwand bei der Herstellung von Schaltungsplatinen bzw. Baugruppen mit programmierbaren integrierten Schaltkreisen zu reduzieren. Die Aufgabe wird ausgehend von den im Oberbegriff des Patentanspruchs 1 genannten Merkmalen durch dessen kennzeichnende Merkmale gelöst.

Der wesentliche Aspekt des erfindungsgemäßen Verfahrens ist darin zu sehen, daß außer den programmierbaren integrierten Schaltkreisen auch weitere auf der Schaltungsplatine angeordnete elektronische Elemente zur Funktionsprüfung über die Meßfühler mit der Programmier- und Prüfeinrichtung verbunden werden.

In der Prüfeinrichtung werden die schaltkreisspezifischen Programmiersignale - üblicherweise sind dies Programmierspannungssignale mit vorgegebenen Pegel - vorteilhaft in einer Anpassungseinrichtung realisiert und die schaltkreiszeit- und adressenspezifische Steuerung der gebildeten Programmierspannungssignale durch die Programmierroutine bewirkt - Anspruch 2. Die Anpassungseinrichtung ist für die Anpassung der physikalischen Eigenschaften der durch die Meßfühler gemessenen Informationen und der an die Meßfühler übermittelten Informationen - z. B. Einstellinformationen, üblicherweise bereits realisiert und muß lediglich um die Mittel zur Erzeugung der schaltkreisspezifischen Programmierspannungssignale ergänzt werden. Die Programmierspannungssignale können sehr unterschiedliche Pegel aufweisen und sind Je nach Typ des programmierbaren integrierten Schaltkreises spezifisch zu bestimmen. Die zeitgerechte Steuerung der Programmierspannungssignale, d. h. im wesentlichen die Zeitdauer je Programmierzyklus, erfolgt durch die Programmierroutine. Des weiteren wird durch die Programmierroutine die adressenspezifische Programmierung des programmierbaren integrierten Schaltkreises bewirkt. Hierbei wird in Abhängigkeit des Typs des zu programmierenden integrierten Schaltkreises die Adressen- bzw. Adreßinformation schrittweise vorgegeben und das einzuspeichernde Programm an der durch die Adreßinformation vorgegebenen Speicherbereich der programmierbaren integrierten Schaltkreise hinterlegt bzw. gespeichert.

Der wesentliche Vorteil des erfindungsgemäßen Verfahrens ist darin zu sehen, daß alle Maßnahmen, die hinsichtlich einer separaten Programmierung auf einem speziellen Programmierplatz und einer programmindividuellen Lagerhaltung der programmierten integrierten Schaltkreise erforderlich sind, nunmehr eingespart werden können. Hierdurch wird eine erhebliche Kostenreduzierung bei der Herstellung von Schaltungsplatinen bzw. Baugruppen mit programmierbaren integrierten Schaltkreisen erreicht.

Das erfindungsgemäße Verfahren wird des weiteren besonders vorteilhaft bei der Umprogrammierung von bereits programmierten, auf einer Schaltungsplatine bzw. einer Baugruppe aufgebrachten integrierten Schaltkreisen eingesetzt - Anspruch 3. Hierdurch können schaltungstechnisch gleiche Schaltungsplatinen bzw. Baugruppen einfach und ohne großen Aufwand für andere Einsatzfälle umprogrammiert werden.

Besonders vorteilhaft wird das erfindungsgemäße Verfahren zusätzlich bei der Programmierung von programmierbaren integrierten Schaltkreisen mit einfachem Programmierrhythmus angewandt - Anspruch 4, da die für die Programmierung erforderliche Programmierroutine in der Prüfeinrichtung hierbei besonders einfach, d. h. wirtschaftlich, zu realisieren ist. Die Kontaktierung der Anschlußelemente der programmierbaren integrierten Schaltkreise wird vorteilhaft unter Mitbenutzung bereits vorhandener Nadeladapter - durch Federkraft oder pneumatisch gesteuert - durchgeführt - Anspruch 5.

Im folgenden wird das erfindungsgemäße Verfahren anhand einer figürlichen Darstellung erläutert.

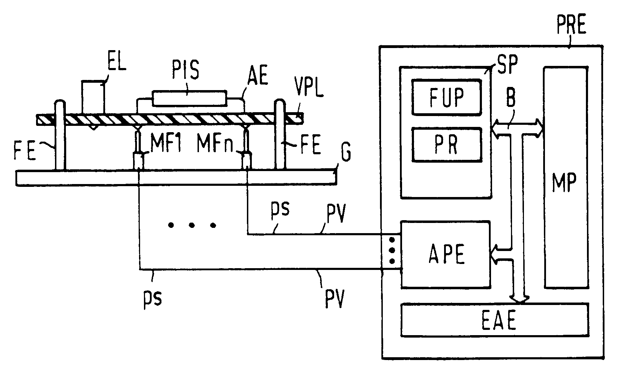

Die FIGUR zeigt eine Prüfeinrichtung PRE, die im wesentlichen durch einen Mikroprozessor MP, durch eine Anpassungseinrichtung APE, durch eine Speichereinrichtung SP und durch eine Ein-/Ausgabeeinrichtung EAE gebildet ist. Der Informationsaustausch zwischen diesen Komponenten wird durch ein vom Mikroprozessor MP gesteuertes Bussystem B bewirkt. In der Speichereinrichtung SP ist ein Programm für die Funktionsprüfung FUP und für die Programmierung PR von programmierbaren integrierten Schaltkreisen gespeichert. In der Anpassungseinrichtung APE werden die für die Funktionsprüfung und für die Programmierung erforderlichen Prüfspannungen bzw. Programmierspannungen ps erzeugt und über Prüfverbindungen PV an Meßfühler MF1...MFn geführt. Des weiteren werden in dieser Anpassungseinrichtung APE die von den Meßfühlern MF1...MFn übermittelten Meßinformationen mit Hilfe von beispielsweise Analog-/Digital-Wandlern (nicht dargestellt) in für eine weitere Verarbeitung vorgesehene digitale Meßinformationen umgesetzt. Mit Hilfe der Ein-/Ausgabeeinrichtung EAE werden die Funktionsprüfprogramme FUP sowie die Programmierroutinen PR initialisiert und Funktionsprüfergebnisse bzw. Meßinformationen an einer hierfür vorgesehenen, nicht dargestellten, Anzeigeeinrichtung dargestellt.

Die Meßfühler MF1...MFn sind beispielsweise Kontaktnadeln, die mit Hilfe von Federkräften oder pneumatischen Kräften gegen den Meßpunkt gedrückt werden. Die Meßpunkte stellen gemäß der FIGUR die in einer Verdrahtungsplatte VPL eingelöteten Anschlußelemente AE eines programmierbaren integrierten Schaltkreises PIS dar. Der programmierbare integrierte Schaltkreis PIS ist beispielsweise durch einen PLA-Baustein (Programmable Logic Array) realisiert. Auf der Verdrahtungsplatte VPL sind üblicherweise weitere elektronische Bauelemente vorhanden, die in der FIGUR beispielhaft durch das schaltungstechnische Element EL repräsentiert sind. In die im Schnittbild dargestellte Verdrahtungsplatte VPL greifen im Sinne einer Verdrahtungsplattenhalterung Führungselemente FE ein, die auf einer Grundplatte G angeordnet sind.

Mit Hilfe der Prüfeinrichtung PRE wird vor der Funktionsprüfung der Verdrahtungsplatte VPL die Programmierung des programmierbaren integrierten Schaltkreises PIS initialisiert, d. h. der Ablauf einer vorgegebenen Programmierungsroutine PR eingeleitet. Mit Hilfe dieser Programmierungsroutine PR werden gemäß des in den programmierbaren integrierten Schaltkreis PIS einzuspeichernden Programms die in der Anpassungseinrichtung APE erzeugten schaltkreisspezifischen Programmierspannungssignale ps entsprechend der für den PLA-Baustein erforderlichen Programmierzeiten an die mit den Anschalteelementen APE kontaktierten Meßfühlern MF1...MFn gesteuert. Die Anzahl und Position der Meßfühler MF1...MFn ist auf die für die Programmierung erforderliche Anzahl und Position der Anschlußelemente AE abgestimmt. Nach dem durch die Programmierungsroutine PR gesteuerten Programmieren des programmierbaren integrierten Schaltkreises PIS kann anschließend sofort die Funktionsprüfung sowohl des programmierbaren integrierten Schaltkreises PIS als auch der weiteren, auf der Verdrahtungsplatte VPL angeordneten elektronischen Elemente EL durchgeführt werden. Die Meßfühler MF1...MFn sind hierbei an die entsprechenden Meßpunkte der Verdrahtungsplatte VPL zu steuern. Dies kann beispielsweise durch Verschieben der Verdrahtungsplatte VPL oder durch die Anordnung der Meßfühler MF1...MFn bewirkt werden. Durch das erfindungsgemäße Programmieren und das Prüfen mit Hilfe der Meßfühler MF1...MFn und der Prüfeinrichtung PRE kann sowohl auf eine Programmierung in einer speziellen Programmiereinrichtung als auch auf die programmindividuelle Lagerhaltung verzichtet werden, wodurch eine erhebliche Einsparung von Herstellungskosten von bestückten Verdrahtungsplatten VPL bzw. Baugruppen erzielt wird.

## Patentansprüche

1. Verfahren zum Programmieren von programmierbaren integrierten Schaltkreisen (IS), die auf einer Schaltungsplatine (VPL) angeordnet sind, und zur Funktionsprüfung, mit einer Programmier- und Prüfeinrichtung (PRE),
wobei die programmierbaren integrierten Schaltkreise (IS), mit Hilfe von zumindest einer in der Programmier- und Prüfeinrichtung (PRE) vorgesehenen schaltkreisspezifischen Programmierroutine (PR) und Mitteln zur Erzeugung von schaltkreisspezifischen Programmiersignalen (ps) über, mit den für die Programmierung vorgesehenen Anschlußelementen, kontaktierbare Meßfühler (MF1..MFn), programmiert werden, und die programmierbaren integrierten Schaltkreise (IS) im Sinne einer Funktionsprüfung mit den, mit der Programmier- und Prüfeinrichtung (PRE) verbundenen, Meßfühlern (MF1...MFn) kontaktiert werden,
**dadurch gekennzeichnet,** daß außer den programmierbaren integrierten Schaltkreisen (IS) auch weitere auf der Schaltungsplatine (VPL) angeordnete elektronische Elemente (EL) zur Funktionsprüfung über die Meßfühler (MF1..MFn) mit der Programmier- und Prüfeinrichtung (PRE) verbunden werden.

2. Verfahren nach Anspruch 1, **dadurch gekennzeichnet,** daß in der Prüfeinrichtung (PRE) die schaltkreisspezifischen Programmierspannungssignale in einer Anpassungseinrichtung (APE) gebildet und die schaltkreiszeit- und adressenspezifische Steuerung dieser Signale durch die Programmierroutinen (PR) bewirkt wird.

3. Verfahren nach Anspruch 1 oder 2, **dadurch gekennzeichnet,** daß mit Hilfe der Meßfühler (MF1...MFn) und der Prüfeinrichtung (PRE) programmierte integrierte Schaltkreise (PIS) umprogrammierbar sind.

4. Verfahren nach einem der vorhergehenden Ansprüche, **dadurch gekennzeichnet,** daß die Programmierung vorzugsweise für integrierte Schaltkreise (PIS) mit einfachen Programmiermodi vorgesehen ist.

5. Verfahren nach einem der vorhergehenden Ansprüche, **dadurch gekennzeichnet,** daß die Programmierung über, durch Nadeladapter realisierte, Meßfühler (MF1...MFn) durchgeführt wird.

## Claims

1. Method for programming programmable integrated circuits (IS), which are arranged on a circuit board (VPL), and for functional testing, with a programming and testing device (PRE),
the programmable integrated circuits (IS) being programmed, with the aid of at least one circuit-specific programming routine (PR), which is provided in the programming and testing device (PRE), and means for generating circuit-specific programming signals (ps), via measurement sensors (MF1...MFn) which can make contact with the terminal elements provided for programming, and contact being made with the programmable integrated circuits (IS) with the aim of functional testing, by the measurement sensors (MF1...MFn), which are connected to the programming and testing device (PRE),
characterized in that, in addition to the programmable integrated circuits (IS), further electronic elements (EL), which are arranged on the circuit board (VPL), are connected to the programming and testing device (PRE) for the purpose of functional testing via the measurement sensors (MF1...MFn).

2. Method according to Claim 1, characterized in that, in the testing device (PRE), the circuit-specific programming voltage signals are formed in an adapting device (APE) and the circuit time- and address-specific control of these signals is effected by the programming routines (PR).

3. Method according to Claim 1 or 2, characterized in that it is possible to reprogramme integrated circuits (PIS) programmed with the aid of the measurement sensors (MF1...MFn) and the testing device (PRE).

4. Method according to one of the preceding claims, characterized in that the programming is preferably provided for integrated circuits (PIS) with simple programming modes.

5. Method according to one of the preceding claims, characterized in that the programming is carried out via measurement sensors (MF1...MFn) realized by needle adaptors.

## Revendications

1. Procédé de programmation de circuits intégrés programmables (IS), qui sont montés sur une plaquette de circuits imprimés (VPL), et comprenant, pour le test fonctionnel, un dispositif de programmation et de test (PRE),
les circuits intégrés programmables (IS) étant programmés à l'aide d'au moins une routine de programmation (PR), spécifique aux circuits et prévue dans le dispositif de programmation et de test (PRE), et de moyens pour produire des signaux de programmation (ps) spécifiques aux circuits, par l'intermédiaire de capteurs (MF1 à MFn) pouvant être mis en contact avec les éléments de connexion prévus pour la programmation, et
les circuits intégrés programmables (IS) étant mis en contact en vue d'un test fonctionnel avec les capteurs (MF1 à MFn) reliés au dispositif de programmation et de test (PRE),
caractérisé par le fait que, outre les circuits intégrés programmables (IS), d'autres éléments électroniques (EL) montés sur la plaquette de circuits imprimés (VPL) sont reliés pour le test fonctionnel par l'intermédiaire des capteurs (MF1 à MFn) au dispositif de programmation et de test (PRE).

2. Procédé selon la revendication 1, caractérisé par le fait que, dans le dispositif de test (PRE), les signaux de tension de programmation spécifiques aux circuits sont formés dans un dispositif d'adaptation (APE) et les routines de programmation (PR) effectuent la commande des adresses et du temps, spécifiques aux circuits, de ces signaux.

3. Procédé selon la revendication 1 ou 2, caractérisé par le fait que l'on peut reprogrammer des circuits intégrés programmés (PIS) à l'aide des capteurs (MF1 à MFn) et du dispositif de test (PRE).

4. Procédé selon l'une des revendications précédentes, caractérisé par le fait que l'on prévoit la programmation de préférence pour des circuits intégrés (PIS) ayant des modes de programmation simples.

5. Procédé selon l'une des revendications précédentes, caractérisé par le fait que l'on effectue la programmation par l'intermédiaire de capteurs (MF1 à MFn) mis en oeuvre sous forme d'adaptateurs à aiguilles.
